# FASCICULE DE BREVET EUROPEEN

(11) **EP 0 831 590 B1**
(45) Date de publication et mention de la délivrance du brevet: **17.03.1999**
(21) Numéro de dépôt: 97470021.3
(22) Date de dépôt: 11.09.1997
(51) Int. Cl.: H03K 19/0185, H03K 19/003, G11C 8/00

(54) **Circuit tampon de sortie de signaux logiques**
Ausgangspufferschaltkreis für logische Signale
Output buffer for logic signals

(30) Priorité: 18.09.1996 FR 9611533
(43) Date de publication de la demande: 25.03.1998
(73) Titulaire: STMicroelectronics S.A., 94250 Gentilly (FR)
(72) Inventeur: Gaultier, Jean-Marie, Cabinet Ballot Schmit, 57000 Metz (FR)
(74) Mandataire: Schmit, Christian Norbert Marie

(56) Documents cités:
- EP-A- 0 536 929
- WO-A-94/26030
- PATENT ABSTRACTS OF JAPAN vol. 018, no. 039 (P-1679), 20 janvier 1994 & JP 05 265791 A (SONY CORP), 15 octobre 1993,

## Description

L'invention concerne le domaine des circuits tampons de sortie de signaux logiques. Elle trouve une application dans tout circuit produisant des signaux logiques, tels par exemple que les mémoires.

Dans un circuit, les circuits tampons de sortie sont des circuits généralement placés entre les circuits logiques internes dudit circuit et des sorties ou entrées/sorties de ce circuit. Ils permettent de fournir à des circuits externes des signaux logiques produits par les circuits internes, en les adaptant aux caractéristiques électriques de ces circuits externes.

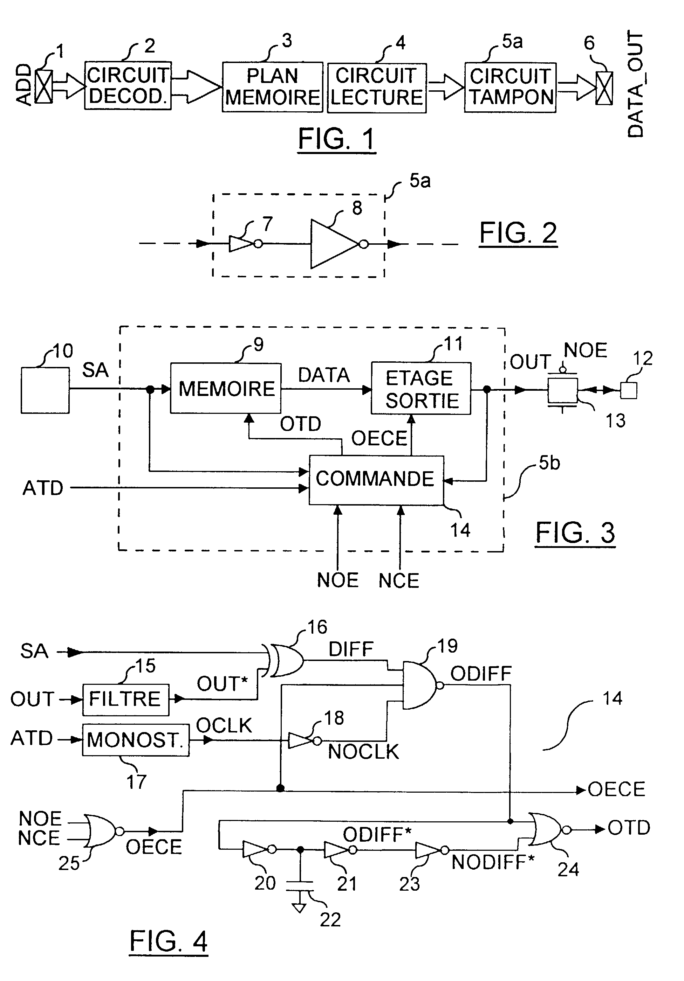

La figure 1 illustre très schématiquement un exemple d'application d'un circuit tampon de sortie, en l'occurrence dans une mémoire. La mémoire comprend un port 1 d'entrée d'adresse pour recevoir des adresses ADD d'informations à lire dans la mémoire. Ces adresses sont fournies à un circuit de décodage 2 qui produit les signaux de sélection adéquats pour lire dans un plan mémoire 3 les informations correspondants aux adresses reçues. Un circuit de lecture 4 permet d'extraire du plan mémoire les informations recherchées. Ces informations DATA_OUT sont fournies sur un port 6 de sortie, sous la forme de signaux logiques, par le biais d'un circuit tampon 5a.

La figure 2 illustre un exemple classique de circuit tampon 5a. Il comprend deux inverseurs 7 et 8 montés en série, l'inverseur 7 recevant les signaux extraits par le circuit de lecture 4, et l'inverseur 8 fournissant ces signaux au port 6. On choisira un inverseur 8 réalisé avec des transistors de dimension relativement importantes de telle sorte qu'ils puissent être traversés par un courant important. Cette précaution vient du fait que les ports de sortie sont typiquement reliés à des bus de communication. Ces bus peuvent être de longueur importante et un nombre importants de circuits autres que la mémoire peuvent y être reliés. De ce fait la capacité équivalente vue par la mémoire sur le port 6 est généralement importante. Le temps de chargement de cette capacité équivalente quand la mémoire fournit des signaux sur le port 6 sera d'autant moins long que le courant fourni par la mémoire sur le port sera important.

L'inverseur 7 a pour fonction d'inverser le signal fourni à l'inverseur 8 de telle sorte que la polarité des signaux reçus et fournis par le circuit tampon soient identiques.

Si les informations se présentent sous la forme d'ensembles de N signaux logiques, comme c'est le cas dans les mémoires de type parallèle, on utilise bien sûr un nombre N de circuits tampon.

Un problème posé par ce type de circuit tampon est sa sensibilité par rapport au bruit. Ainsi, la commutation dans les inverseurs 7 et 8 du circuit tampon illustré sur la figure 2 peut induire une perturbation du fonctionnement dans le circuit de lecture 4 fournissant les signaux logiques. Typiquement, les perturbations sont dues au fait que la commutation génère du bruit sur les alimentations au moment des transitions d'état. Ce bruit se traduit par des rebonds sur les alimentations, par effet inductif ou capacitif. Or, les circuits de lecture utilisent généralement des amplificateurs différentiels, ce qui les rend très sensibles aux variations des potentiels d'alimentation. On peut également induire des phénomènes d'oscillation entre le circuit 4 et la sortie du circuit 5a.

Un but de l'invention est de proposer un circuit tampon de sortie qui minimise ces problèmes de perturbation par bouclage entre le circuit tampon de sortie et les circuits placés en amont de celui-ci.

Pour ce faire, on propose de contrôler temporellement le transfert de signaux vers la sortie et de n'effectuer le transfert que s'il est nécessaire, de sorte d'une part à limiter toute influence de la commutation dans le circuit tampon sur le fonctionnement des circuits placés en amont, et d'autre part à supprimer tout effet de bouclage entre la sortie et ces circuits placés en amont.

Ainsi l'invention propose un circuit tampon de sortie de signaux logiques produisant un signal logique de sortie à partir d'un signal logique d'entrée. Il comprend un circuit de mémorisation apte à mémoriser l'état logique du signal d'entrée et un étage de sortie pour produire le signal de sortie en fonction de l'état logique mémorisé dans le circuit de mémorisation. Un circuit de commande comprend un circuit de comparaison des signaux d'entrée et de sortie. Le circuit de commande produit un signal de commande de réactualisation dont l'état logique est représentatif de la relation existant entre les états logiques des signaux d'entrée et de sortie, ce signal de réactualisation commandant la mémorisation dans le circuit de mémorisation de l'état du signal d'entrée.

D'autres avantages et particularités apparaîtront à la lecture de la description qui suit d'un exemple de réalisation de l'invention à lire conjointement aux dessins annexés dans lesquels:
- la figure 1 représente schématiquement une mémoire,
- la figure 2 représente un circuit tampon selon l'état de la technique,
- la figure 3 représente un circuit tampon selon l'invention,
- la figure 4 représente un circuit de commande mise en oeuvre dans le circuit tampon selon l'invention,
- la figure 5 représente un circuit de filtrage mis en oeuvre dans le circuit de commande illustré sur la figure 4,
- la figure 6 représente un circuit de mémorisation mis en oeuvre dans le circuit tampon selon l'invention,
- la figure 7 représente un circuit de sortie mis en oeuvre dans le circuit tampon selon l'invention,
- les figures 8a à 8h représentent des chronogrammes de signaux logiques représentatif du fonctionnement du circuit tampon quand l'état d'un signal d'entrée est modifié dans un délai donné,
- les figures 9a à 9h représentent des chronogrammes de signaux logiques représentatif du fonctionnement du crcuit tampon quand l'état d'un signal d'entrée est modifié après un délai donné,
- les figures 10a à 10f représentent des chronogrammes de signaux logiques représentatif du fonctionnement du circuit tampon quand une sortie de ce circuit est mise en état de haute impédance, et
- les figures 11a à 11f représentent des chronogrammes de signaux logiques représentatif du fonctionnement du circuit tampon quand une impulsion parasite perturbe l'état d'un signal d'entrée.

Dans l'exemple décrit ci-dessous d'un circuit tampon selon l'invention, on considérera une utilisation de ce circuit dans une mémoire telle qu'illustrée schématiquement sur le figure 1. Cette application ne saurait être limitative et le circuit tampon selon l'invention pourra être mis en oeuvre en aval de tout circuit produisant des signaux logiques. Par ailleurs on considérera des signaux logiques à deux états, respectivement un état haut et un état bas. L'état haut correspondra à un potentiel positif d'alimentation VCC, et l'état bas à un potentiel de masse GND.

La figure 3 illustre schématiquement un circuit tampon de sortie de signaux logiques 5b réalisé conformément à l'invention. Ce circuit 5b reçoit en entrée un signal logique d'entrée SA et produit à partir de celui-ci un signal logique de sortie OUT. Le signal SA est fourni sur une sortie d'un circuit 10 placé en amont du circuit tampon. Le circuit 10 sera typiquement, dans l'application considérée, un amplificateur de lecture produisant un signal logique représentatif de l'état électrique d'une cellule de mémorisation d'un plan mémoire.

Le signal OUT est fourni à une sortie qui pourra être une broche de sortie. Tel qu'illustré sur la figure 3, on considère une entrée/sortie 12, auquel cas on isole de manière classique le circuit tampon 5b de la sortie 12 par un interrupteur CMOS 13 commandé par un signal logique NOE de commande de sens de transfert (plus connu en anglais sous l'expression "Output Enable"). Quand le signal NOE est dans un premier état (dans l'exemple on a choisi l'état bas), l'entrée/sortie 12 est configurée en sortie, et est reliée au circuit 5b. Quand le signal NOE est dans un deuxième état (dans l'exemple on a choisi l'état haut), l'entrée/sortie 12 est configurée en entrée et est isolée du circuit 5b par l'interrupteur 13. Le signal NOE sera typiquement un signal reçu sur une entrée du circuit dans lequel est utilisé le circuit tampon. Comme on le verra par la suite, le circuit tampon comprend un étage de sortie réalisé de telle sorte que la présence de l'interrupteur 13 est superflue.

Comme on va le voir plus en détail, on va isoler le circuit tampon 5b du circuit 10 pendant la phase de lecture par ce circuit 10, autrement dit pendant la phase de production du signal d'entrée SA.

Un circuit de mémorisation compris dans le circuit tampon 5b permet de mémoriser l'état du signal SA durant cette phase. On réactualise le contenu du circuit de mémorisation à des instants contrôlés de sorte à éviter tout bouclage de la sortie sur laquelle est fourni le signal de sortie OUT vers le circuit 10 produisant le signal d'entrée SA. De plus, cette réactualisation n'est effectuée que si l'état du signal SA a été modifié durant la phase de lecture. Si la production du signal SA est tardive, et s'effectue après que la durée standard nécessaire à une lecture du plan mémoire soit écoulée, la réactualisation s'effectue si on détecte une différence entre les signaux d'entrée SA et de sortie OUT. Suite à la réactualisation, on interdit toute commutation pendant le laps de temps nécessaire à la commutation dans le circuit tampon, de sorte à éviter l'apparition de rebonds.

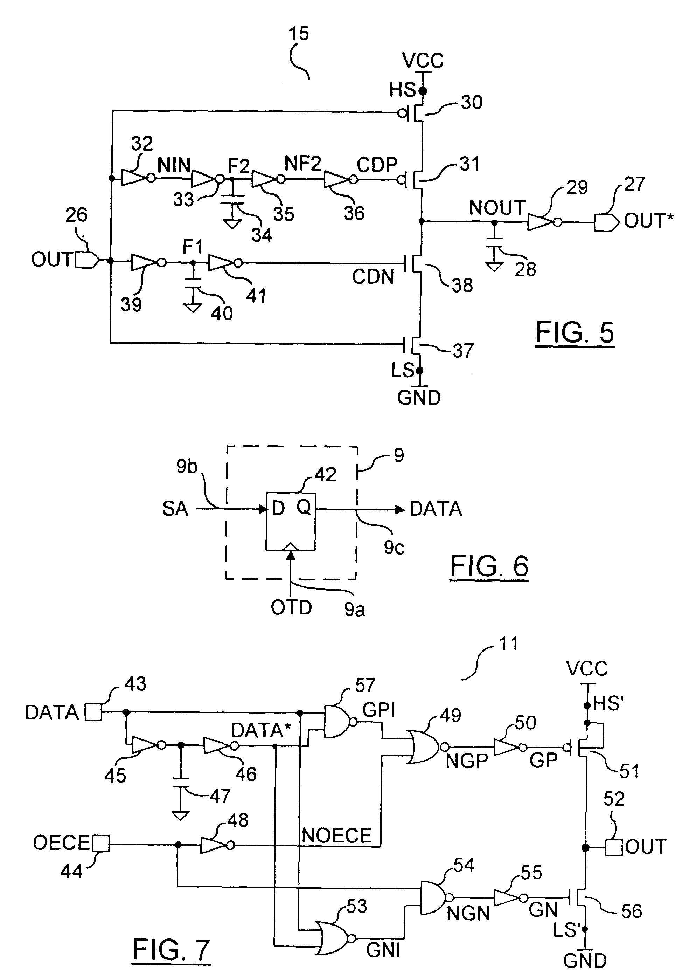

Le circuit 5h comprend un circuit de mémorisation 9 pour mémoriser l'état du signal logique d'entrée SA fourni par le circuit 10. Le circuit 9 (illustré sur la figure 6) comprend une entrée de commande 9a pour recevoir un signal OTD de commande de réactualisation, une entrée 9b pour recevoir le signal SA, et une sortie 9c pour fournir un signal logique intermédiaire DATA dont l'état est représentatif de l'état du signal SA mémorisé.

Le circuit 5b comprend également un étage de sortie 11 (illustré sur le figure 7) qui reçoit sur une entrée 43 le signal intermédiaire DATA. L'étage de sortie 11 produit sur une sortie 52 le signal de sortie OUT. Il comprend une entrée de commande 44 pour recevoir un signal logique OECE de commande de validation.

Les signaux de commande de réactualisation et de validation OTD et OECE sont fournis par un circuit de commande 14, ce circuit comprenant des entrées pour recevoir les signaux d'entrée et de sortie SA et OUT, le signal NOE de commande de sens de transfert, et des signaux NCE et ATD de commande classiques de sélection de circuit (plus connu en anglais sous l'expression "Chip Enable") et de détection de transition d'adresse.

Le signal NCE de sélection de circuit est un signal logique fourni aux circuits de manière classique pour en commander le mode. Selon l'état du signal NCE on utilise la mémoire en mode normal (on peut alors y accéder pour la programmer et/ou la lire) ou en mode basse-consommation. Dans l'exemple on sélectionne la mémoire en positionnant le signal NCE à l'état bas.

Le signal ATD est, dans les mémoires, un signal classique produit par le circuit de décodage pour indiquer qu'un changement d'état s'est produit sur une ou plusieurs entrées d'adresse, autrement dit qu'une nouvelle adresse a été fournie à la mémoire. On supposera que la détection d'un changement d'état se traduit par une impulsion positive de durée déterminée dans le signal ATD, la durée étant généralement très inférieure au temps d'accès typique en lecture (c'est-à-dire à la durée moyenne entre le moment où une adresse est fournie à la mémoire et le moment où le ou les signaux correspondants sont produits par le ou les circuits de lecture).

La figure 4 illustre un exemple de réalisation d'une partie du circuit de commande 14.

Le signal de validation OECE est produit par un circuit logique et son état est tel qu'il est dans un premier état si la mémoire est sélectionnée et si l'entrée/sortie 12 est configurée en sortie, et dans un deuxième état sinon. Le circuit logique est une porte logique 25 de type NON_OU à deux entrées qui reçoit les signaux NOE et NCE sur ses entrées et produit le signal OECE sur une sortie. Ainsi, si les signaux NCE et NOE sont à l'état bas, on produit un signal OECE à l'état haut qui est représentatif du fait que l'on peut lire des informations dans la mémoire qui utilise le circuit tampon 5b.

Le circuit 14 comprend un circuit de filtrage 15 pour éliminer du signal de sortie OUT d'éventuelles impulsions parasites. Ce circuit produit un signal logique filtré OUT*.

On utilise le signal filtré OUT* pour comparer les états en entrée et en sortie du circuit tampon 5b. A cet effet, le circuit 5b comprend un circuit de comparaison qui produit un signal logique de comparaison DIFF dont l'état est représentatif des états relatifs des signaux SA et OUT. Quand les signaux SA et OUT sont dans des états différents, le signal DIFF est dans un premier état. Quand ces signaux sont dans le même état, le signal DIFF est dans un second état. Dans l'exemple, le circuit de comparaison est une porte logique 16 de type OU_EXCLUSIF à deux entrées qui reçoit les signaux SA et OUT* sur ses entrées et produit le signal DIFF. Le premier état du signal DIFF correspond dans l'exemple à l'état haut et le second état correspond à l'état bas.

Un circuit monostable 17 permet de produire à partir du signal ATD un signal d'horloge OCLK de telle sorte que ce signal OCLK passe dans un premier état durant un délai Toclk déterminé quand on détecte une transition d'adresse en entrée de la mémoire, et qu'il soit dans un second état sinon. Typiquement, on dimensionnera le circuit monostable de tel sorte que ce délai soit, d'une part, au moins égal au délai typique entre le moment ou une adresse est connue de la mémoire et le moment où les signaux correspondants sont produits par le ou les circuits de lecture, et, d'autre part, inférieur au délai minimum imposé entre deux transitions d'adresse successives. Le premier état du signal OCLK correspond dans l'exemple à un état haut et le deuxième état à un état bas.

Le signal d'horloge OCLK est utilisé pour produire le signal OTD.

Le signal OTD de commande de réactualisation est produit par un circuit logique de telle sorte qu'on lui fasse subir une transition d'un premier état vers un deuxième état quand on souhaite mémoriser l'état du signal SA dans le circuit de mémorisation 9. Pour ce faire, on lui fait subir tout d'abord une première transition du second état vers le premier état, avant de le ramener au deuxième état. Le signal OTD est donc dans l'exemple un signal impulsionnel. Il commande, comme on le verra, le verrouillage dans une bascule D. Dans l'exemple, le premier état considéré sera l'état haut et le deuxième état sera l'état bas.

Quand une lecture est initiée par une transition d'adresse, on mémorise dans le circuit de mémorisation 9 l'état du signal SA résultant de cette lecture à la condition que, d'une part, les signaux d'entrée SA et de sortie OUT soient différents et que, d'autre part, le signal OCLK soit dans son second état (autrement dit que le délai standard de lecture soit écoulé). Dans l'exemple, on conditionne de plus la mémorisation dans le circuit 9 au fait que la mémoire soit sélectionnée (NCE = 0) et que l'entrée/sortie 12 soit configurée en sortie.

Pour produire le signal OTD, on met en oeuvre un inverseur 18 qui produit un signal logique NOCLK inverse du signal OCLK. Une porte logique 19 de type NON_ET à trois entrées reçoit sur ses entrées les signaux DIFF, OECE et NOCLK. Cette porte 19 produit à partir des signaux reçus un signal logique ODIFF. Le signal ODIFF produit passe dans un premier état, en l'occurrence l'état bas, quand les conditions posées pour induire une mémorisation du signal d'entrée SA dans le circuit de mémorisation 9 sont réunies. Sinon, il est dans un deuxième état, en l'occurrence l'état haut.

Un circuit à retard produit à partir du signal ODIFF un signal logique retardé ODIFF*. Ce circuit à retard comprend deux inverseurs 20 et 21 montés en série et une capacité 22. L'inverseur 20 reçoit sur une entrée le signal ODIFF. Une sortie de l'inverseur 20 est reliée à une entrée de l'inverseur 21 et à un premier pôle de la capacité 22. Un deuxième pôle de la capacité 22 est relié à la masse. L'inverseur 21 fourni le signal ODIFF* sur une sortie. Un inverseur 23 reçoit le signal ODIFF* sur une entrée et produit sur une sortie un signal logique NODIFF*, inverse du signal ODIFF*. Une porte logique 24 de type NON_OU à deux entrées reçoit sur ses entrées les signaux ODIFF et NODIFF*. Cette porte 24 produit le signal de commande de réactualisation OTD. La valeur de la capacité 22 permet de dimensionner le délai pendant lequel le signal OTD passe à l'état haut. Le signal OTD étant fourni à une bascule D, on mémorisera dans cette bascule l'état du signal SA quand un front descendant apparaîtra dans le signal OTD.

La figure 5 illustre un exemple de circuit 15 de filtrage.

Il comprend une entrée 26 pour recevoir le signal logique OUT que l'on souhaite filtrer et une sortie 27 pour produire le signal filtré OUT* à partir du signal OUT. Le circuit comprend un premier étage de type inverseur qui produit un signal NOUT accessible aux bornes d'une capacité 28 de mémorisation. Le signal OUT* est produit par un inverseur 29 à partir du signal NOUT.

L'étage inverseur comprend des moyens de connexion pour relier une première borne de la capacité 28 à des noeuds électriques de référence HS et LS dont les potentiels sont respectivement représentatifs des états haut et bas que peut prendre le signal OUT. Une deuxième borne de la capacité est connectée à une masse. Les moyens de connexion sont des transistors de type MOS commandés en fonction de l'état du signal d'entrée OUT. Pour relier la première borne de la capacité au noeud HS (porté au potentiel VCC), on utilise deux transistors 30 et 31 de type MOS à canal P. La source du transistor 30 est reliée au noeud HS. Sa grille de commande reçoit le signal OUT. Son drain est relié à la source du transistor 31. Le drain du transistor 31 est relié à la première borne de la capacité 28. Sa grille de commande reçoit un signal logique de commande CDP produit à partir du signal OUT.

Pour produire le signal CDP on utilise un inverseur 32 qui reçoit le signal OUT en entrée et qui produit un signal logique NIN qui est l'inverse du signal OUT. Un inverseur 33 reçoit le signal NIN en entrée. L'inverseur 33 a une sortie reliée à une première borne d'une capacité 34. La capacité 34 a une deuxième borne qui est reliée à la masse. On note F2 le signal présent sur la première borne de la capacité 34. Un inverseur 35 a une entrée reliée à cette première borne et produit sur une sortie un signal logique NF2. Un inverseur 36 reçoit le signal NF2 sur une entrée et produit le signal CDP par inversion du signal NF2.

Pour relier la première borne de la capacité au noeud LS (porté au potentiel GND), on utilise deux transistors 37 et 38 de type MOS à canal N. La source du transistor 37 est reliée au noeud LS. Sa grille de commande reçoit le signal OUT. Son drain est relié à la source du transistor 38. Le drain du transistor 38 est relié à la première borne de la capacité 28. Sa grille de commande reçoit un signal logique de commande CDN produit à partir du signal OUT.

Pour produire le signal CDN on utilise un inverseur 39 qui reçoit le signal OUT en entrée et qui a une sortie reliée à une première borne d'une capacité 40. La capacité 40 a une deuxième borne qui est reliée à la masse. On note F1 le signal présent sur la première borne de la capacité 40. Un inverseur 41 a une entrée reliée à cette première borne et produit sur une sortie le signal CDN.

Les transistors 31 et 38 sont utilisés pour filtrer les impulsions parasites. Sera considéré comme une impulsion parasite une impulsion de durée inférieure à une durée donnée, typiquement de l'ordre de grandeur de la nanoseconde.

Les transistors 30 et 37 sont commandés de telle sorte que les noeuds HS et LS soient toujours isolés l'un de l'autre, ce qui permet d'éviter de produire des impulsions parasites par court-circuit des noeuds HS et LS quand le signal OUT change d'état.

Supposons que le signal OUT soit à l'état haut et qu'un front descendant apparaisse dans le signal. Avant que le front apparaisse, les transistors 37 et 38 sont passants et les transistors 30 et 31 sont bloqués. La première borne de la capacité 28 est alors reliée à la masse et par suite le signal OUT* est à l'état haut. Quand le front descendant apparaît, le transistor 37 se bloque et le transistor 30 devient passant. Les capacités 40 et 34 vont respectivement se charger et se décharger. Tant que les seuils de basculement des inverseurs 41 et 35 n'ont pas été atteints, les signaux de commande CDN et CDP restent dans les états dans lesquels ils étaient avant l'apparition du front. Autrement dit le transistor 38 est passant et le transistor 31 est bloqué. La capacité 28 est alors isolée des noeuds HS et LS et maintient le signal OUT* à l'état haut.

Si le signal OUT reste à l'état bas les transistors 31 et 38 vont devenir respectivement passant et bloqué une fois les seuils de basculement des inverseurs 35 et 41 sont atteints. La capacité 28 est alors reliée au noeud HS et va se charger, entraînant un passage à l'état bas du signal OUT*.

Si le signal OUT repasse à l'état haut avant que les seuils des inverseurs 41 et 35 n'aient été atteints, on va revenir dans la configuration précédant l'apparition du front descendant. Les transistors 30 et 37 vont redevenir respectivement bloqué et passant et la capacité 28 sera reliée au noeud LS. Le transistor 31 n'ayant jamais été passant, l'impulsion négative délimitée par les fronts successifs aura été ignorée.

La largeur maximale des impulsions négatives qui sont filtrées est déterminée par les dimensionnements de la capacité 34 et de la résistance entre la sortie de l'inverseur 33 et la masse (c'est-à-dire, pour un inverseur CMOS classique, par les dimensions du transistor MOS à canal N monté entre cette sortie et la masse), cette capacité et cette résistance définissant un filtre RC au travers duquel on décharge la capacité 34.

Supposons que le signal OUT soit à l'état bas et qu'un front montant apparaisse dans le signal. Avant que le front apparaisse, les transistors 30 et 31 sont passants et les transistors 37 et 38 sont bloqués. La première borne de la capacité 28 est alors reliée au noeud HS et le signal OUT* est à l'état bas.

Quand le front montant apparaît, le transistor 30 se bloque et le transistor 37 devient passant. Les capacités 34 et 40 vont respectivement se charger et se décharger. Tant que les seuils de basculement des inverseurs 35 et 41 n'ont pas été atteints, les signaux de commande CDN et CDP restent dans les états dans lesquels ils étaient avant l'apparition du front. Autrement dit le transistor 31 est passant et le transistor 38 est bloqué. La capacité 28 est alors isolée des noeuds HS et LS et maintient le signal OUT* à l'état bas.

Si le signal OUT reste à l'état haut les transistors 38 et 31 vont devenir respectivement passant et bloqué une fois les seuils de basculement des inverseurs 41 et 35 sont atteints. La capacité 28 est alors reliée au noeud LS et va se décharger, entraînant un passage à l'état haut du signal OUT*.

Si le signal OUT repasse à l'état bas avant que les seuils des inverseurs 41 et 35 n'aient été atteints, on va revenir dans la configuration précédant l'apparition du front montant. Les transistors 37 et 30 vont redevenir respectivement bloqué et passant et la capacité 28 sera reliée au noeud HS. Le transistor 38 n'ayant jamais été passant, l'impulsion positive délimitée par les fronts successifs aura été ignorée.

La largeur maximale des impulsions positives qui sont filtrées est déterminée par les dimensionnements de la capacité 40 et de la résistance entre la sortie de l'inverseur 39 et la masse (c'est-à-dire, pour un inverseur CMOS classique, par les dimensions du transistor MOS à canal N monté entre cette sortie et la masse), cette capacité et cette résistance définissant un filtre RC au travers duquel on décharge la capacité 40.

La figure 6 illustre un exemple de réalisation du circuit 9 de mémorisation. Il comprend une bascule 42 de type D recevant sur son entrée D le signal SA, fournissant sur sa sortie Q le signal DATA, et dont le fonctionnement est piloté par le signal OTD.

La figure 7 illustre un exemple de réalisation de l'étage de sortie 11.

Un circuit à retard permet de produire un signal logique retardé DATA* à partir du signal DATA. Ce circuit à retard comprend deux inverseurs 45 et 46 montés en série et une capacité 47. L'inverseur 45 reçoit sur une entrée le signal DATA. Une sortie de l'inverseur 45 est reliée à une entrée de l'inverseur 46 et à un premier pôle de la capacité 47. Un deuxième pôle de la capacité 47 est relié à une masse. L'inverseur 46 fournit le signal DATA* sur une sortie.

Une porte logique 57 de type NON_ET à deux entrées et une sortie reçoit les signaux DATA et DATA* sur ses entrées et produit un signal logique GPI sur sa sortie. Un inverseur 48 reçoit le signal OECE sur une entrée et produit sur une sortie un signal logique NOECE qui est l'inverse du signal OECE. Une porte logique 49 de type NON_OU reçoit sur deux entrées les signaux GPI et NOECE et produit sur une sortie un signal logique NGP. Un inverseur 50 reçoit sur une entrée le signal NGP et produit sur une sortie un signal logique GP, qui est l'inverse du signal NGP.

Un transistor 51 de type MOS à canal P permet d'imposer le potentiel VCC sur la sortie 52. La grille de commande du transistor 51 reçoit le signal GP. Sa source est relié à un noeud HS' qui est au potentiel VCC, et son drain est relié à la sortie 52.

Une porte logique 53 de type NON_OU reçoit sur deux entrées les signaux DATA et DATA* et produit sur une sortie un signal logique GNI. Une porte logique 54 de type NON_ET reçoit sur deux entrées les signaux GNI et OECE et produit sur une sortie un signal logique NGN. Un inverseur 55 reçoit sur une entrée le signal NGN et produit sur une sortie, à partir de celui-ci, un signal logique GN, qui est l'inverse du signal NGN.

Un transistor 56 de type MOS à canal N permet d'imposer le potentiel GND sur la sortie 52. Le transistor 56 a sa source reliée à un noeud LS' qui est au potentiel GND. Son drain est relié à la sortie 52. Sa grille de commande reçoit le signal GN.

Supposons que les signaux DATA et DATA* sont à l'état haut et que le signal DATA passe à l'état bas suite à une lecture.

Initialement, avant la transition d'état, les signaux GPI et GNI sont à l'état bas. En conséquence, si on suppose que la mémoire est sélectionnée et que l'entrée/sortie 12 est configurée en sortie, les signaux NGP et NGN sont à l'état haut. Les signaux GP et GN sont donc à l'état bas. Le transistor 51 est donc passant et le transistor 56 est bloqué. Le signal de sortie OUT est donc dans le même état que le signal DATA.

Quand le signal DATA passe à l'état bas, le signal GPI passe à l'état haut. Le signal GNI reste inchangé tant que le signal DATA* n'a pas changé d'état. Le signal GPI étant passé à l'état haut, le signal NGP va passer à l'état bas et le signal GP va passer à l'état haut, bloquant le transistor 51. Une fois que le signal DATA* passe à l'état bas, le signal GNI passe à l'état haut. Par conséquent, le signal NGN passe à l'état bas et le signal GN passe à l'état haut. Le transistor 56 devient passant et le signal OUT passe alors dans le même état que le signal DATA.

Si on choisit la valeur de la capacité 47 relativement au temps de traversée des circuits logiques de telle sorte que les transistors 51 et 56 soient bloqués simultanément avant que le transistor 56 ne devienne passant, on évite de produire du bruit sur les alimentations. On évite ainsi de perturber le fonctionnement des circuits tels que le circuit de lecture. D'autre part, on évite ainsi de créer une consommation résistive dans les transistors 51 et 56. Cela est d'autant plus intéressant que l'on emploie des transistors de dimension importante, aptes à délivrer un courant important. Par contre, le maintien de l'état du signal OUT en sortie sera alors conditionné par la valeur de la capacité équivalente vue par le circuit tampon 5b sur sa sortie 52. Le maintien de l'état en sortie suppose donc que la sortie 52 soit non isolée, auquel cas cette sortie serait alors flottante. On prendra donc soin de ne pas choisir une valeur trop importante pour la capacité 47 afin de ne pas prolonger longtemps cet état de haute impédance.

Supposons maintenant que les signaux DATA sont à l'état bas et que le signal DATA passe à l'état haut suite à une lecture.

Initialement, avant la transition d'état, les signaux GPI et GNI sont à l'état haut. En conséquence, si on suppose que la mémoire est sélectionnée et que l'entrée/sortie 12 est configurée en sortie, les signaux NGP et NGN sont à l'état bas. Les signaux GP et GN sont donc à l'état haut. Le transistor 56 est donc passant et le transistor 51 est bloqué. Le signal de sortie OUT est donc dans le même état que le signal DATA.

Quand le signal DATA passe à l'état haut, le signal GNI passe à l'état bas. Le signal GPI reste inchangé tant que le signal DATA* n'a pas changé d'état. Le signal GNI étant passé à l'état bas, le signal NGN va passer à l'état haut et le signal GN va passer à l'état bas, bloquant le transistor 56. Une fois que le signal DATA* passe à l'état haut, le signal GPI passe à l'état bas. Par conséquent, le signal NGP passe à l'état haut et le signal GP passe à l'état bas. Le transistor 51 devient passant et le signal OUT passe dans le même état que le signal DATA.

On va maintenant décrire quelques exemples illustrant le comportement du circuit tampon de sortie 5b.

### 1 - lecture 'standard', quand le signal OCLK est à l'état haut.

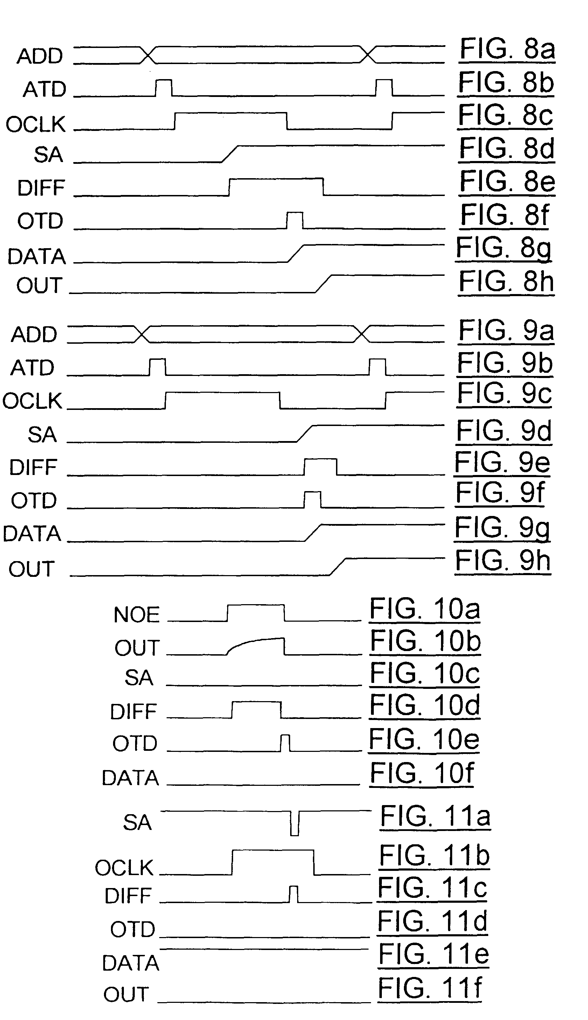

Cet exemple est illustré sur les figures 8a à 8h.

On suppose que le signal OECE est à l'état haut et que les signaux SA, DATA et OUT (illustrés sur les figures 8d, 8g et 8h) sont dans le même état, par exemple l'état bas. Le signal de comparaison DIFF (illustré sur la figure 8e) est donc à l'état bas. En conséquence, le signal OTD (illustré sur la figure 8f) est à l'état bas.

Parallèlement, les signaux ATD et OCLK (illustrés sur les figures 8b et 8c) sont à l'état bas.

Supposons que la mémoire détecte une transition sur l'entrée d'adresse ADD (illustré sur la figure 8a).

Le signal ATD va monter à l'état haut avant de redescendre à l'état bas. En conséquence, le signal OTD monte à l'état haut pour une durée Toclk.

Si l'état du signal SA correspondant à la nouvelle adresse est identique à l'état précédent, le signal DIFF reste à l'état bas. Par conséquent, le signal OTD va rester également à l'état bas. On ne réactualise donc pas le contenu de la bascule 42 et les signaux DATA et OUT restent dans le même état.

Si l'état du signal SA correspondant à la nouvelle adresse est différent à l'état précédent (cas illustré sur les figures 8a à 8h), le signal DIFF va monter à l'état haut quand ce nouvel état va être fourni par le circuit 10 (on suppose ici qu'il est fourni alors que le signal OCLK est à l'état haut).

A la fin du délai Toclk, la descente à l'état bas du signal OCLK va provoquer une montée à l'état haut du signal NOCLK. Par conséquent le signal OTD va monter à l'état haut. Ultérieurement il redescend à l'état bas, ce qui va provoquer l'actualisation du contenu de la bascule 42. Le signal DATA va donc passer à l'état haut, ce qui entraîne une montée à l'état haut du signal OUT.

### 2 - lecture 'lente', une fois le délai Toclk écoulé.

Cet exemple est illustré sur les figures 9a à 9h.

On suppose que le signal OECE est à l'état haut et que les signaux SA, DATA et OUT (illustrés sur les figures 9d, 9g et 9h) sont dans le même état, par exemple l'état bas. Le signal de comparaison DIFF (illustré sur la figure 9e) est donc à l'état bas. En conséquence, le signal OTD (illustré sur la figure 9f) est à l'état bas.

Parallèlement, les signaux ATD et OCLK (illustrés sur les figures 9b et 9c) sont à l'état bas.

Supposons que la mémoire détecte une transition sur l'entrée d'adresse ADD (illustré sur la figure 9a). Le signal ATD va monter à l'état haut avant de redescendre à l'état bas. En conséquence, le signal OTD monte à l'état haut pour une durée Toclk.

On suppose ici que l'état du signal SA correspondant à la nouvelle adresse est fourni par le circuit 10 une fois que le délai Toclk est écoulé.

Si le nouvel état du signal SA est identique à l'état précédent, le signal DIFF reste à l'état bas. Par conséquent, le signal OTD va rester également à l'état bas. On ne réactualise donc pas le contenu de la bascule 42 et les signaux DATA et OUT restent dans le même état.

Si l'état du signal SA correspondant à la nouvelle adresse est différent à l'état précédent (cas illustré sur les figures 9a à 9h), le signal DIFF va monter à l'état haut quand ce nouvel état va être fourni par le circuit 10. Le signal NOCLK est alors à l'état haut. Par conséquent le signal OTD va monter à l'état haut. Ultérieurement il redescend à l'état bas, ce qui va provoquer l'actualisation du contenu de la bascule 42. Le signal DATA va donc passer à l'état haut, ce qui entraîne une montée à l'état haut du signal OUT.

### 3 - modification de sélection de sens de transfert.

Cet exemple est illustré sur les figures 10a à 10f.

On va maintenant étudier l'influence d'une mise en état haute impédance de la sortie 52 par modification de l'état du signal NOE (illustré sur la figure 10a).

On va supposer que les signaux SA, DATA et OUT (illustrés sur les figures 10c, 10f et 10b) sont dans le même état, par exemple l'état bas et que le signal NOE est alors à l'état bas.

Si le signal NOE passe à l'état haut, le signal de sélection OECE passe à l'état bas. Par conséquent, les signaux GP et GN passent respectivement à l'état haut et à l'état bas, ce qui bloque les transistors 51 et 56. La sortie 52 de l'étage de sortie est alors isolée du reste de l'étage de sortie, ce qui ne serait pas le cas avec le circuit de la figure 2. On voit ici que la présence de l'interrupteur 13 n'est pas nécessaire.

Il se peut que l'état du signal OUT se modifie, par exemple si l'interrupteur 13 est absent et qu'un état haut est forcé sur la sortie 12, ou bien encore suite à des fuites. Le signal DIFF (illustré sur la figure 10d) va alors monter à l'état haut. Dès que le signal NOE sera revenu à l'état bas, on va se retrouver dans la configuration correspondant à l'exemple 2. Autrement dit on va produire une modification du signal OTD (illustré sur la figure 10e) qui réactualise le contenu de la bascule 42. Parallèlement, le signal OECE va revenir à l'état haut, et le signal OUT est alors forcé dans l'état précédent la modification du signal NOE, cet état étant ultérieurement confirmé par la réactualisation de la bascule 42.

### 4 - Impulsion parasite dans le signal SA lors du délai Toclk.

Cet exemple est illustré sur les figures 11a à 11f.

Supposons que les signaux SA, DATA et OUT (illustrés sur les figures 1 la, 11e et 11f) sont dans un même état, par exemple l'état haut.

Si une transition d'adresse est détectée le signal OCLK (illustré sur la figure 11b) va passer à l'état haut. Si une impulsion parasite négative apparaît alors dans le signal d'entrée SA, le signal DIFF va changer d'état et monter à l'état haut.

Le signal OTD, initialement à l'état bas, ne sera pas modifié par ce changement d'état du signal DIFF dans la mesure où l'impulsion parasite disparaît avant que le signal OCLK ne revienne à l'état bas. Dans cette hypothèse, les signaux DATA et OUT vont rester inchangés. Avec le circuit de la figure 2, une telle impulsion aurait provoqué une moditication inopinée du signal de sortie.

Bien que l'on ait décrit le circuit tampon selon l'invention en référence à son application dans une mémoire, il va de soit que cette application n'est pas exclusive. On pourra très bien modifier le circuit, sans sortir du cadre de l'invention, pour l'adapter à d'autres applications.

Ainsi, on pourra réaliser un circuit tampon autonome, c'est-à-dire dont le fonctionnement n'est pas conditionné par des signaux de commande extérieurs. Il suffira de modifier en conséquence le circuit de commande et éventuellement l'étage de sortie. Par exemple on pourra ne pas produire de signal de validation OECE, si cela est inutile. On utilisera alors une porte 19 à deux entrées et on remplacera les portes 49 et 54 par des inverseurs. De même, on pourra supprimer les éléments relatifs à la production du signal OCLK, qui trouve un intérêt dans les mémoires pour lesquelles un changement d'état nécessite un certain temps, mais qui n'est pas nécessaire par exemple si le circuit 10 est simplement un circuit logique. On remplacera alors de même la porte 19 par une porte à deux entrées, voire par un inverseur si le signal OECE n'est pas produit.

Enfin, il est bien entendu que l'on pourra modifier la polarité des signaux produits et/ou utiliser des circuits logiques différents pour les produire sans que l'on sorte du cadre de l'invention qui ne saurait se limiter à la réalisation particulière décrite en exemple.

## Revendications

1. Circuit tampon de sortie de signaux logiques (5b) produisant un signal logique de sortie (OUT) à partir d'un signal logique d'entrée (SA),
caractérisé en ce qu'il comprend :
- un circuit de mémorisation (9) apte à mémoriser l'état logique du signal d'entrée (SA),
- un étage de sortie (11) pour produire le signal logique de sortie en fonction de l'état logique mémorisé dans le circuit de mémorisation, et
- un circuit de commande (14) comprenant un circuit (16) de comparaison des signaux d'entrée et de sortie, le circuit de commande produisant un signal de commande de réactualisation (OTD) dont l'état logique est représentatif de la relation existant entre les états logiques des signaux d'entrée et de sortie, ce signal de réactualisation commandant la mémorisation dans le circuit de mémorisation de l'état du signal d'entrée.

2. Circuit selon la revendication 1, caractérisé en ce que le circuit de commande (14) comprend des moyens (17, 18, 19, 20-24) pour retarder la mémorisation de l'état du signal d'entrée dans le circuit de mémorisation quand cet état est modifié.

3. Circuit selon la revendication 2, caractérisé en ce que le circuit de commande comprend des moyens (17) pour produire un signal d'horloge (OCLK) et pour produire le signal de réactualisation (OTD) de sorte l'on ne puisse mémoriser l'état du signal d'entrée dans le circuit de mémorisation qu'à la condition que le signal d'horloge soit dans un premier état et qu'un signal logique de comparaison (DIFF) produit par le circuit (16) de comparaison soit simultanément dans un deuxième état.

4. Circuit selon l'une des revendications 1 à 3, caractérisé en ce que le circuit de commande (14) comprend un circuit de filtrage (15) du signal de sortie (OUT) pour éliminer du signal de sortie les impulsions parasites, le circuit (16) de comparaison recevant le signal d'entrée et un signal logique filtré (OUT*) produit par le circuit de filtrage à partir du signal de sortie.

5. Circuit selon l'une des revendications 1 à 4, caractérisé en ce que l'étage de sortie (11) comprend :
- une sortie (52) pour fournir le signal de sortie (OUT),
- des moyens de connexion (51, 56) pour relier sélectivement, en fonction de l'état mémorisé dans le circuit de mémorisation, la sortie (52) de l'étage à des noeuds électriques (HS', LS') dont les potentiels (VCC, GND) sont représentatifs des états que peut prendre le signal logique de sortie, et
- des moyens de commande (45, 47, 46, 57, 53) pour produire des signaux de commande (GP, GN) de ces moyens de connexion, ces signaux de commande étant produits de sorte que la sortie ne puisse être reliée qu'à un noeud à la fois, les moyens de commande comprenant un circuit à retard (45, 46, 47) pour retarder la modification des signaux de commande de telle sorte qu'avant de relier la sortie à un noeud on isole cette sortie du ou des autres noeuds.

6. Circuit selon la revendication 5, caractérisé en ce que l'étage de sortie comprend une entrée de commande (44) pour recevoir un signal logique de validation (OECE), ce signal étant combiné à un signal intermédiaire (DATA) fourni par le circuit de mémorisation pour produire les signaux de commande (GP, GN) des moyens de connexion (51, 56) de telle sorte que les états de ces signaux de commande soient représentatifs de l'état du signal intermédiaire quand le signal de validation est dans un premier état, et que les états de ces signaux de commande soient tels que la sortie (52) est isolée de tous les noeuds quand le signal de validation est dans un deuxième état.

7. Circuit selon l'une des revendications 1 à 3, caractérisé en ce que le circuit de mémorisation (9) comprend une bascule (42) pour mémoriser l'état du signal d'entrée.

8. Circuit selon la revendication 7, caractérisé en ce que le circuit de commande (14) comprend des moyens (20, 21, 22, 23, 24) pour produire un signal de réactualisation (OTD) de forme impulsionnelle.

## Patentansprüche

1. Ausgangspufferschaltkreis für logische Signale (5b), der aus einem logischen Eingangssignal (SA) ein logisches Ausgangssignal (OUT) erzeugt,
**dadurch gekennzeichnet**, daß er umfaßt:
einen Speicherschaltkreis (9), der dazu dient, den logischen Zustand des Eingangssignals (SA) abzuspeichern,
eine Ausgangsstufe (11) zum Erzeugen des logischen Ausgangssignals in Abhängigkeit von dem in dem Speicherschaltkreis abgelegten logischen Zustand und
einen Steuerschaltkreis (14) mit einem Schaltkreis (16) zum Vergleichen von Eingangs- und Ausgangssignal, wobei der Steuerschaltkreis ein Erneuerungssteuersignal (OTD) erzeugt, dessen logischer Zustand die Beziehung zwischen den logischen Zuständen von Eingangs- und Ausgangssignal wiedergibt, wobei dieses Erneuerungssignal die Abspeicherung in dem Schaltkreis zum Abspeichern des Zustandes des Eingangssignals steuert.

2. Schaltkreis nach Anspruch 1,
**dadurch gekennzeichnet,** daß
der Steuerschaltkreis (14) Mittel (17, 18, 19, 20 - 24) zum Verzögern des Abspeicherns des Zustands des Eingangssignals in dem Speicherschaltkreis umfaßt, wenn dieser Zustand verändert worden ist.

3. Schaltkreis nach Anspruch 2,
**dadurch gekennzeichnet,** daß
der Steuerschaltkreis Mittel (17) zum Erzeugen eines Taktsignals (OCLK) und zum Erzeugen des Erneuerungssignals (OTD) umfaßt, so daß man den Zustand des Eingangssignals in dem Speicherschaltkreis nur unter der Bedingung abspeichern kann, daß das Taktsignal sich in einem ersten Zustand befindet und ein logisches Vergleichssignal (DIFF), das von dem Schaltkreis (16) zum Vergleichen erzeugt worden ist, gleichzeitig sich in einem zweiten Zustand befindet.

4. Schaltkreis nach einem der Ansprüche 1 bis 3,
**dadurch gekennzeichnet,** daß
der Steuerschaltkreis (14) einen Filterschaltkreis (15) für das Ausgangssignal (OUT) umfaßt, um bei dem Ausgangssignal parasitäre Pulse zu eliminieren, wobei der Schaltkreis (16) zum Vergleichen das Eingangssignal und ein logisches gefilteres Signal (OUT*), das durch den Filterschaltkreis aus dem Ausgangssignal erzeugt wurde, empfängt.

5. Schaltkreis nach einem der Ansprüche 1 bis 4,
**dadurch gekennzeichnet,** daß
die Ausgangsstufe (11) umfaßt:
einen Ausgang (52) zum Ausgeben des Ausgangssignals (OUT),
Verbindungsmittel (51, 56), um selektiv in Abhängigkeit von dem in dem Speicherschaltkreis abgelegten Zustand den Ausgang (52) der Stufe mit elektrischen Knoten (HS', LS') zu verbinden, deren Potentiale (VCC, GND) Zustände darstellen, die das Ausgangssignal annehmen kann, und
Mittel zum Steuern (45, 47, 46, 57, 53), um Steuersignale (GP, GN) für die Verbindungsmittel zu erzeugen, wobei diese Steuersignale derart erzeugt werden, daß der Ausgang nur mit einem Knoten zur Zeit verbunden werden kann, wobei die Steuermittel einen Verzögerungsschaltkreis (45, 46, 47) zum Verzögern der Modifizierung von Steuersignalen umfaßt, so daß vor dem Verbinden des Ausgangs mit einem Knoten dieser Ausgang von dem oder den anderen Knoten isoliert wird.

6. Schaltkreis nach Anspruch 5,
**dadurch gekennzeichnet,** daß
die Ausgangsstufe einen Steuereingang (44) zum Empfangen eines logischen Bestätigungssignals (OECE) umfaßt, wobei dieses Signal mit einem Zwischensignal (DATA) von dem Speicheischaltkreis verknüpft wird, um Steuersignale (GP, GN) von Verbindungsmitteln (51, 56) zu erzeugen, so daß die Zustände von diesen Steuersignalen den Zustand des Zwischensignals wiedergeben, wenn das Bestätigungssignal sich in einem ersten Zustand befindet, und die Zustände dieser Steuersignale derart sind, daß der Ausgang (52) von allen Knoten isoliert ist, wenn das Bestätigungssignal sich in einem zweiten Zustand befindet.

7. Schaltkreis nach einem der Ansprüche 1 bis 3,
**dadurch gekennzeichnet,** daß
der Speicherschaltkreis (9) eine Kippstufe (42) zum Ablegen des Zustandes des Eingangssignals umfaßt.

8. Schaltkreis nach Anspruch 7,
**dadurch gekennzeichnet,** daß
der Steuerschaltkreis (14) Mittel (20, 21, 22, 23, 24) umfaßt, um ein Erneuerungssignal (OTD) in Pulsform zu erzeugen.

## Claims

1. Output buffer circuit for logic signals (5b) producing an output logic signal (OUT) from an input logic signal (SA),
characterised in that it comprises:
- a storage circuit (9) able to store the logic state of the input signal (SA),
- an output stage (11) for producing the output logic signal according to the logic state stored in the storage circuit, and
- a control circuit (14) comprising a circuit (16) for comparing the input and output signals, the control circuit producing a re-updating control signal (OTD) whose logic state represents the relationship existing between the logic states of the input and output signals, this re-updating signal controlling the storage of the state of the input signal in the storage circuit.

2. Circuit according to Claim 1, characterised in that the control circuit (14) comprises means (17, 18, 19, 20-24) for delaying the storage of the state of the input signal in the storage circuit when this state is modified.

3. Circuit according to Claim 2, characterised in that the control circuit comprises means (17) for producing a clock signal (OCLK) and producing the re-updating signal (OTD) so that the state of the input signal can be stored in the storage circuit only provided that the clock signal is in a first state and a comparison logic signal (DIFF) produced by the comparison circuit (16) is at the same time in a second state.

4. Circuit according to one of Claims 1 to 3, characterised in that the control circuit (14) comprises a circuit (15) for filtering the output signal (OUT) in order to illuminate the parasitic pulses from the output signal, the comparison circuit (16) receiving the input signal and a filtered logic signal (OUT*) produced by the filtering circuit from the output signal.

5. Circuit according to one of Claims 1 to 4, characterised in that the output stage (11) comprises:
- an output (52) for supplying the output signal (OUT),
- connection means (51, 56) for selectively connecting the output (52) of the stage, according to the state stored in the storage circuit, to electrical nodes (HS', LS') whose potentials (VCC, GND) represent the states which the output logic signal can take, and
- control means (45, 47, 46, 57, 53) for producing control signals (GP, GN) for these connection means, these control signals being produced so that the output can be connected only to one node at a time, the control means comprising a delay circuit (45, 46, 47) for delaying the modification of the control signals so that, before connecting the output to a node, this output is isolated from the other node or nodes.

6. Circuit according to Claim 5, characterised in that the output stage comprises a control input (44) for receiving an enable logic signal (OECE), this signal being combined with an intermediate signal (DATA) supplied by the storage circuit in order to produce the control signals (GP, GN) for the connection means (51, 56) so that the states of these control signals represent the state of the intermediate signal when the enable signal is in a first state, and the states of these control signals are such that the output (52) is isolated from all the nodes when the enable signal is in a second state.

7. Circuit according to one of Claims 1 to 3, characterised in that the storage circuit (9) comprises a flip-flop (42) for storing the state of the input signal.

8. Circuit according to Claim 7, characterised in that the control signal (14) comprises means (20, 21, 22, 23, 24) for producing a re-updating signal (OTD) with a pulsed form.
